# EUROPEAN PATENT APPLICATION

(11) **EP 2 933 832 A1**
(43) Date of publication of application: **21.10.2015**
(21) Application number: 13861981.2
(22) Date of filing: 13.12.2013
(51) Int. Cl.: H01L 23/427, H05K 7/20

(54) **COOLING APPARATUS**

(30) Priority: 14.12.2012 JP 2012273325
(71) Applicant: Furukawa Electric Co., Ltd., Chiyoda-ku Tokyo 100-8322 (JP)
(72) Inventor: YAMADA Hiroshi, Tokyo 100-8322 (JP); OKAMOTO Tsuyoshi, Tokyo 100-8322 (JP); ISEMURA Masakazu, Tokyo 100-8322 (JP); HASHIMOTO Nobuyuki, Tokyo 100-8322 (JP)
(74) Representative: Jordan, Volker Otto Wilhelm
(86) International application number: PCT/JP2013/083431
(87) International publication number: WO 2014/092176

(57) **Abstract**

Provided is a cooling apparatus that can prevent an increase in the installation space and an increase in power consumption and can increase the cooling capacity at the downstream side. A cooling apparatus (1) of the present invention includes a heat receiving block (11) that is thermally connected to a heating element (10-1 to 10-8), a heat pipe group (12) that is thermally connected to the heat receiving block, and a heat dissipation fin group (13) that is thermally connected to the plurality of heat pipes. The heat pipe group (12) has a heat pipe unit (12-1) disposed upstream in a cooling air, the heat pipe unit (12-1) being constituted by a plurality of heat pipes (12A) disposed substantially perpendicularly to the flow direction F of the cooling air, and a heat pipe unit (12-2) disposed downstream in the cooling air (F), the heat pipe unit (12-2) being constituted by a plurality of heat pipes (12B) disposed substantially parallel to the flow direction (F) of the cooling air.

## Description

### Technical Field

The present invention relates to a cooling apparatus that cools a heating element by forced air-cooling, and particularly relates to a forced air-cooling type cooling apparatus that cools an electrical component such as a power converter installed in a transporter such as a railway vehicle.

### Background Art

Conventionally, as a forced air-cooling type cooling apparatus for cooling a plurality of electrical components, a cooling apparatus exists that includes a heat receiving block, a plurality of U-shaped (or L-shaped) heat pipes secured to the heat receiving block, and a heat dissipation fin group attached to the heat pipes (see patent document 1). In such a cooling apparatus, usually, U-shaped (L shaped) heat pipes are arranged in arrays with all of them being either in parallel with, or perpendicular to, a flow direction of a cooling air.

### Document List

### Patent Document(s)

Patent Document 1: Japanese Laid-Open Patent Publication No. 2011-181882

### Summary of Invention

### Technical Problem

In a prior art cooling apparatus, in a case where heat pipes are in a parallel arrangement, a cooling capacity on a downstream side tends to decrease due to a pressure loss produced by, for example, heat pipes and heat dissipation fins disposed upstream in the cooling air. In a case of a perpendicular arrangement, fin efficiency decreases, and thus a cooling capacity tends to decrease not only on the downstream side but also on the upstream side. Accordingly, in order to further increase the cooling capacity, the number of fins for cooling may be increased or an air volume of the cooling air may be increased. However, such measures may cause an increase in man-hours, and may also require a greater installation space for the cooling apparatus or produce a greater power consumption.

It is an object of the present invention to provide a cooling apparatus that can prevent an increase in an installation space or a power consumption, and can increase a cooling capacity on the downstream side.

### Solution to Problem

In order to achieve the above mentioned object, a cooling apparatus includes a heat receiving block that is thermally connected to a heating element, a heat pipe group that is thermally connected to the heat receiving block, and a heat dissipation fin group that is thermally connected to the plurality of heat pipes, the heat pipe group having a first heat pipe unit disposed at an upstream of a cooling air, the first heat pipe unit being constituted by a plurality of heat pipes disposed substantially perpendicularly to the flow direction of the cooling air, and a second heat pipe unit disposed downstream in the cooling air, the second heat pipe unit being constituted by a plurality of heat pipes disposed substantially parallel to the flow direction of the cooling air.

Preferably, the first heat pipe unit is constituted by a plurality of U-shaped or L-shaped heat pipes, the heat pipe having a first secured portion secured to the heat receiving block and a first extended portion that extends from at least one end of the first secured portion, a plane specified by the first secured portion and the first extended portion being disposed substantially perpendicular to the flow direction of the cooling air.

Preferably, the second heat pipe unit is constituted by a plurality of U-shaped or L-shaped heat pipes, the heat pipe having a second secured portion secured to the heat receiving block and a second extended portion that extends from at least one end of the second secured portion, a plane specified by the second secured portion and the second extended portion being substantially parallel to the flow direction of the cooling air.

Further, the first heat pipe unit is constituted by the plurality of heat pipes arranged in rows, the first heat pipe unit having one heat pipe row in which the heat pipes are arranged in a row at a predetermined pitch, and another heat pipe row in which the heat pipes are arranged in a row at a pitch different from the predetermined pitch.

Further, the one heat pipe row has an arrangement pitch of 1/α of a width dimension of the heat dissipation fin (α is an integer greater than or equal to 2), and the other heat pipe row has an arrangement pitch of 1/β of the width dimension of the heat dissipation fin (β≠α, β is an integer greater than or equal to 2).

Further, the one heat pipe row and the other heat pipe row are arranged alternately in the flow direction of the cooling air.

Further, the second heat pipe unit is constituted by a plurality of heat pipes arranged in rows at a predetermined pitch.

### Effects of Invention

In accordance with the present invention, a first heat pipe unit is disposed upstream in a cooling air, and the first heat pipe unit is constituted by a plurality of heat pipes disposed substantially perpendicularly to a flow direction of the cooling air. A second heat pipe unit is disposed downstream in the cooling air, and the second heat pipe unit is constituted by a plurality of heat pipes disposed substantially parallel to the flow direction of the cooling air. According to the present embodiment, since fresh cooling air passes through the first heat pipe unit disposed as described above, a pressure loss can be reduced while maintaining a cooling capacity. Further, since a sufficient air volume of cooling air passes through the second heat pipe unit disposed as described above, a decrease in air volume at the second heat pipe unit can be suppressed, while improving a cooling capacity by high fin efficiency. As a result, it is possible to achieve equalization of temperatures of heating elements disposed along the flow direction of the cooling air. Also, since it is not necessary to increase the number of fins or the number of heat pipes, or to provide a large-sized fan for increasing an air volume, an increase in an installation space for the cooling apparatus or an increase in power consumption can be avoided.

### Brief Description of Drawings

[Fig. 1] FIG. 1 is a perspective view schematically showing a configuration of a cooling apparatus according to a first embodiment of the present invention.
[Fig. 2] FIG. 2 is a side view of the cooling apparatus shown in FIG. 1.
[Fig. 3] FIG. 3A is a cross sectional view taken along line A-A in FIG. 1; and FIG. 3B is a cross sectional view taken along line B-B in FIG. 1.
[Fig. 4] FIG. 4 is a plan view of the cooling apparatus shown in FIG. 1.
[Fig. 5] FIG. 5A is a plan view showing a flow direction of a cooling air in the cooling apparatus of FIG. 1; FIG. 5B is an enlarged view showing a relationship between an arrangement of a heat pipe 12A and the flow direction; and FIG. 5C is an enlarged view showing a relationship between an arrangement of a heat pipe 12B and the flow direction.
[Fig. 6] FIG. 6 is a perspective view schematically showing the configuration of a cooling apparatus according to a second embodiment of the present invention.
[Fig. 7] FIG. 7 is a plan view of the cooling apparatus shown in FIG. 6.
[Fig. 8] FIG. 8 is a diagram showing an arrangement of heating elements when obtaining a heat receiving block temperature by numerical analysis.
[Fig. 9] FIG. 9 is a graph indicating the temperature of the heat receiving block in Examples and Prior Art Examples obtained by numerical analysis.
[Fig. 10] FIG. 10 is a diagram showing a variant of the first heat pipe unit shown in FIG. 1.
[Fig. 11] FIG. 11 is a diagram showing a variant of the first heat pipe unit shown in FIG. 6.
[Fig. 12] FIG. 12 is a diagram showing a variant of the heat dissipation fin group shown in FIG. 1.

### Description of the Preferred Embodiments

Hereinafter, an embodiment of the present invention will be described in detail with reference to the accompanying drawings.

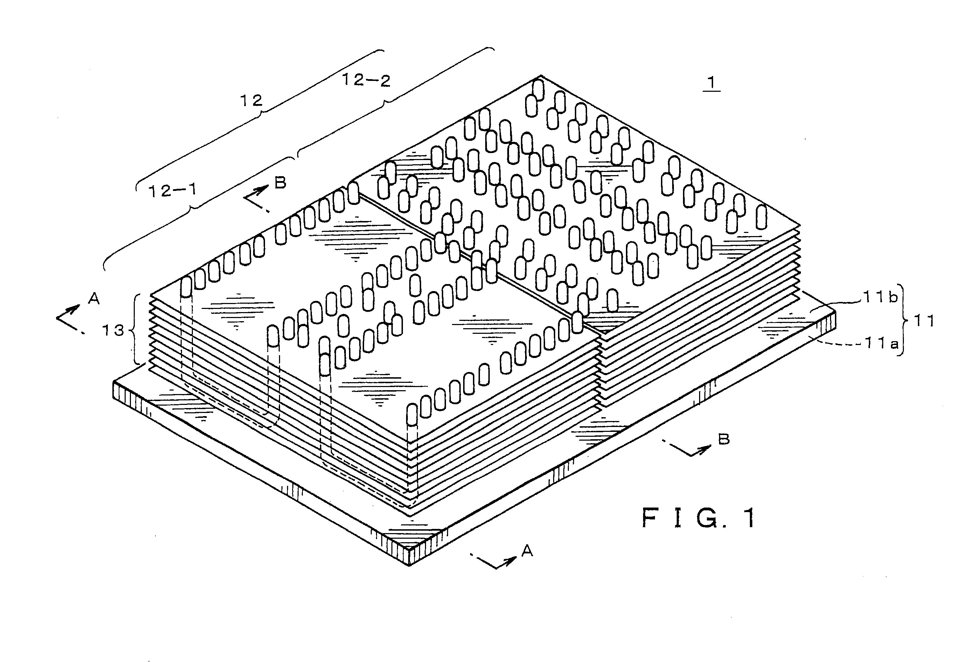

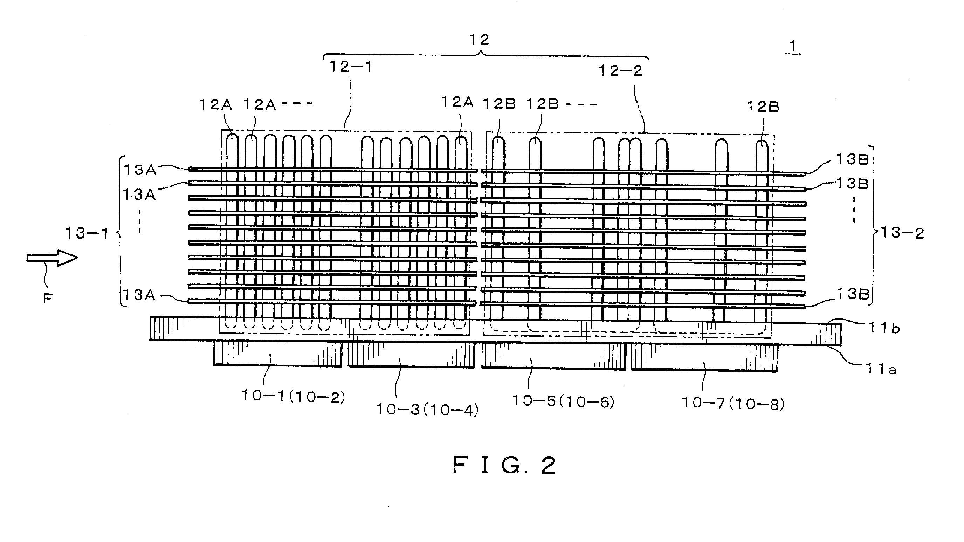

FIG. 1 is a perspective view schematically showing the configuration of a cooling apparatus according to a first embodiment of the present invention, and FIG. 2 is a side view of the cooling apparatus shown in FIG. 1. It is to be noted that the number of heat pipes and the number of fins in FIG. 1 are shown by way of example, and the number of heat pipes and the number of fins of the cooling apparatus according to the present invention are not limited to those shown in FIG. 1.

As shown in FIG. 1, a cooling apparatus 1 of the present invention includes a heat receiving block 11 thermally connected to heating elements 10-1 to 10-8, a heat pipe group 12 thermally connected in the heat receiving block and a heat dissipation fin group 13 thermally connected to a plurality of heat pipes.

The heat receiving block 11 is a flat plate-like member having a predetermined thickness. The heating elements 10-1 to 10-8 are attached to one surface 11a of the heat receiving block 11, and the heat pipe group 12 is attached to the other surface 11b of the heat receiving block 11. It is to be noted that, when a direction substantially parallel to a flow direction F of a cooling air is defined as lengthwise of the heat receiving block 1 and a direction substantially perpendicular to the flow direction F is defined as widthwise of heat receiving block 11, a width and a length of the heat receiving block 11 may be selected from various dimensions depending on dimensions and an amount of heat generation of the heating elements 10-1 to 10-8.

The heat pipe group 12 is constituted by, for example, a plurality of heat pipes having a substantially U-shape in a side view, and each heat pipe is disposed substantially perpendicularly to the heat receiving block 11.

In the present embodiment, the heat pipe group 12 has a heat pipe unit 12-1 (first heat pipe unit) disposed upstream in the cooling air, the heat pipe unit 12-1 being constituted by a plurality of heat pipes 12A disposed substantially perpendicularly to the flow direction F of the cooling air, and a heat pipe unit 12-2 (second heat pipe unit) disposed downstream in the cooling air F, the heat pipe unit 12-2 being constituted by a plurality of heat pipes 12B that are disposed substantially parallel to the flow direction F of the cooling air.

That is, the heat pipe 12A in the heat pipe unit 12-1 is disposed substantially perpendicularly to the flow direction F, and the heat pipe 12B in the heat pipe unit 12-2 is disposed substantially parallel to the flow direction F. In other words, each heat pipe in the heat pipe unit 12-1 is disposed so as to be substantially perpendicular to any of the heat pipes in the heat pipe unit 12-2.

The plurality of heat pipes 12A in the heat pipe unit 12-1 are disposed in an array at an equal interval along the flow direction F of the cooling air. The plurality of heat pipes 12B in the heat pipe unit 12-2 are disposed at an equal interval substantially in parallel with the flow direction F of the cooling air.

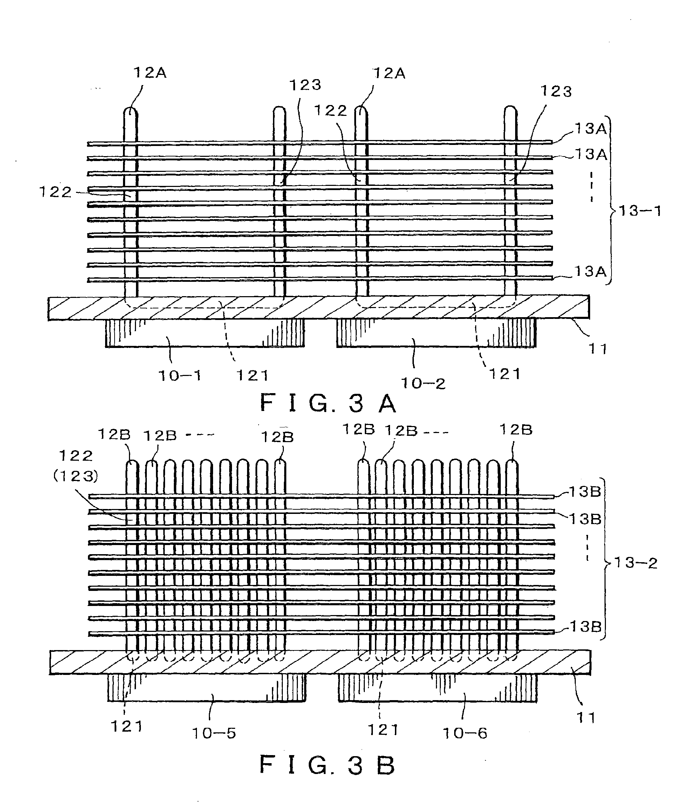

As shown in FIG. 3A, the heat pipe 12A has a secured portion 121 (first secured portion) secured to the heat receiving block 11 and extended portions 122 and 123 (first extended portion) that extend substantially perpendicularly from both ends of the secured portion. The secured portion 121 is secured by being embedded on the surface 11b side of the heat receiving block 11, and the extended portions 122 and 123 extend substantially perpendicularly to the surface 11b of the heat receiving block 11.

In the heat pipe 12A described above, the secured portion 121 serves as a heat input portion (evaporation portion), and the extended portions 122 and 123 serve as a heat dissipation portion (condensation portion). Specifically, when heat released from the heat dissipation elements 10-1 to 10-8 is transferred to the secured portion 121, a working fluid evaporates at the secured portion 121 and the vapor reaches the extended portions 122 and 123. The vapor which has reached the extended portions 122 and 123 condenses and liquefies at an inner wall of the extended portion and releases latent heat. The released latent heat is transferred to the heat pipes and the fins, and is released to an external air. Also, the working fluid which has liquefied circulates to the secured portion 121 by capillarity of a wick (not shown) or the like disposed in the heat pipe. The working fluid returns to the secured portion 121 and the aforementioned cycle is repeated to thereby transport heat continuously.

Similarly to the heat pipe 12A, the heat pipe 12B has a secured portion 121' (second secured portion) that is secured to heat receiving block 11 and extended portions 122' and 123' (second extended portion) that extends substantially perpendicularly from both ends of the secured portion (FIG. 3B). Since the configuration of the heat pipe 12B is basically the same as that of the heat pipe 12A, an explanation thereof is omitted.

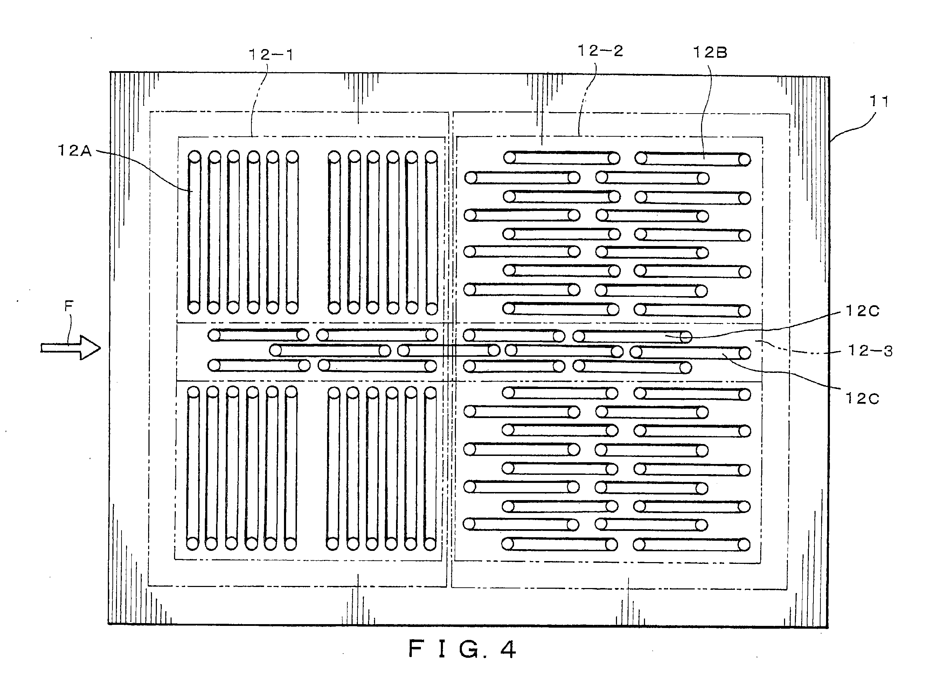

Also, as shown in FIG. 4, the heat pipe group 12 has a heat pipe unit 12-3 that is formed throughout from an upstream side to a downstream side, and constituted by a plurality of heat pipes 12C disposed substantially parallel to the flow direction F of the cooling air. This heat pipe unit 12-3 is disposed at a substantially central part of the heat pipe unit 12-1, and it is disposed at a substantially central part of the heat pipe unit 12-2. Each heat pipe 12C of the heat pipe unit 12-3 is disposed to be substantially perpendicular to any of the heat pipes in the heat pipe unit 12-1, and it is disposed substantially parallel to any of the heat pipes in the heat pipe unit 12-2. Since the configuration of the heat pipe 12C is basically the same as those of the heat pipes 12A and 12B, an explanation thereof is omitted.

The heat dissipation fin group 13 has a fin unit 13-1 including a plurality of fins 13A attached to the heat pipe unit 12-1 and a fin unit 13-2 including a plurality of fins 12B attached to the heat pipe unit 12-2 (FIG. 2).

The plurality of fins 13A are disposed substantially parallel to the surface 11b of the heat receiving block 11, and arranged at an equal interval. The fin 13A is constituted by, for example, a rectangular thin plate member, and a plurality of fins 13A are disposed with their edge portions being aligned when viewed in a plan view. Similarly, the plurality of fins 13B are also disposed substantially parallel to the surface 11b of the heat receiving block 11, and arranged at an equal interval. The fin 13B is constituted by, for example, a rectangular thin plate member, and a plurality of fins 13B are disposed with their edge portions being aligned when viewed in a plan view. It is to be noted that, in the present embodiment, the number of fins 12A attached to the heat pipe unit 12-1 is the same as the number of fins 12B attached to the heat pipe unit 12-2.

A plurality of holes are formed in the fin 13A at predetermined positions and the extended portions of the heat pipe 12A are fitted into the hole, respectively, to thereby secure the fin 13A to the heat receiving block 11 via the heat pipe 12A. A plurality of holes are also formed in the fin 13B at predetermined positions and the extended portions of the corresponding heat pipe 12B are fitted into the holes, respectively, to thereby secure the fin 13B to the heat receiving block 11 via the heat pipe 12B.

The heat receiving block 12 and each fin of the heat dissipation fin group 13 are each formed of a thermally conductive material such as, for example, aluminum, an aluminum alloy, copper, a copper alloy or the like. Similarly, a casing of each heat pipe of the heat pipe group 12 is formed of aluminum, an aluminum alloy, copper, a copper alloy or the like. As a working fluid of each heat pipe, for example, pure water is used and enclosed in the casing in a reduced-pressure state.

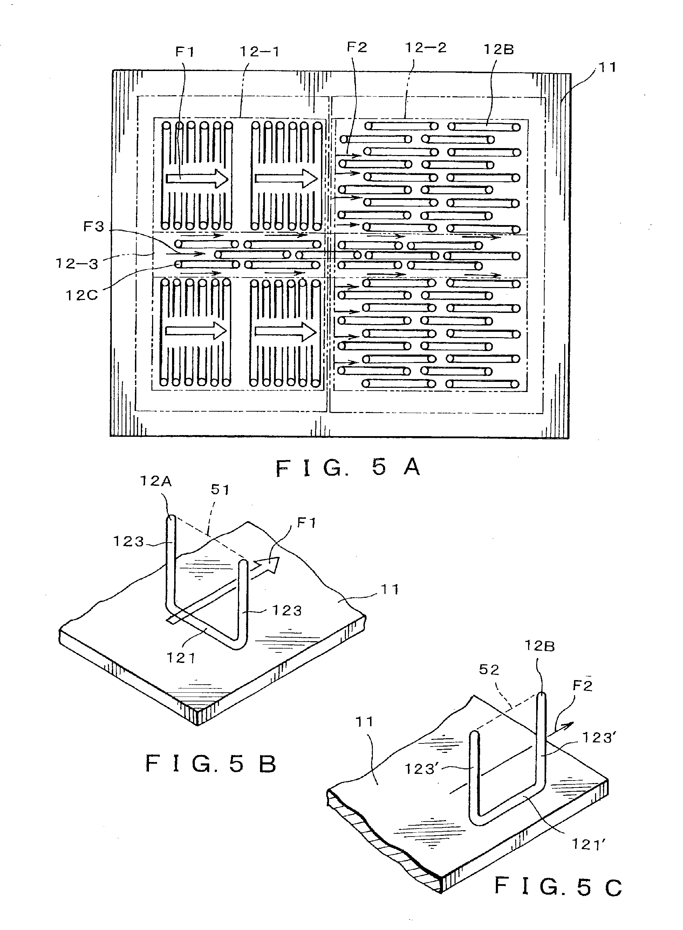

Next, a flow of the cooling air in the cooling apparatus 1 will be described with reference to FIGS. 5A to 5C.

In the cooling apparatus 1 of the present invention, a cooling air is supplied forcibly from the left-hand side in FIG. 1 to pass between the cooling fins of the cooling fin group 13, and is exhausted to the left-hand side. As shown in FIG. 5A, this cooling air passes through the heat pipe unit 12-1 and the heat pipe unit 12-3, and further passes through the heat pipe unit 12-2. Here, a flow direction F1 of the cooling air passing through the heat pipe unit 12-1, is substantially perpendicular to a plane 51 specified by the secured portion 121 and the extended portions 122 and 123 (FIG. 5B). That is to say, in the present embodiment, the flow direction F1 is substantially perpendicular to the secured portion 121 of the heat pipe 12A and is also substantially perpendicular to the extended portions 122 and 123.

In this manner, in the heat pipe unit 12-1, fresh cooling air passes between the plurality of heat pipes 12A that are disposed in arrays in the flow direction F1 of the cooling air, and the plurality of heat pipes 12A are disposed so as not to disturb the flow of the cooling air. Accordingly, although there is a slight decrease in fin efficiency, since there is no significant decrease in cooling capacity and also since the pressure loss is small, a sufficient air volume of cooling air is supplied to the downstream heat pipe unit 12-2.

Also, in the heat pipe unit 12-3, the cooling air passes between the plurality of heat pipes 12C that are densely disposed in a direction substantially parallel to a flow direction F3 at an equal interval. The heat pipe unit 12-3 mainly serves to equalize the air volume of the cooling air that passes through the heat pipe unit 12-1.

Also, a flow direction F2 of the cooling air passing through the heat pipe unit 12-2 is substantially parallel to a plane 52 specified by the secured portion 121' and the extended portions 122' and 123' (FIG. 5C). That is to say, in this embodiment, the flow direction F2 is substantially parallel to the secured portion 121' of the heat pipe 12B and substantially perpendicular to the extended portions 122' and 123'.

In the heat pipe unit 12-2, the cooling air passes between the plurality of heat pipes 12B densely disposed in a direction substantially parallel to the flow direction F2 at an equal interval. As described above, since the pressure loss due to the heat pipe unit 12-1 is reduced, a decrease in air volume at the heat pipe unit 12-2 is suppressed. Also, with the plurality of heat pipe 12B being disposed as described above, fin efficiency improves and a sufficient cooling capacity can be obtained.

According to the present embodiment, since fresh cooling air passes through the heat pipe unit 12-1 disposed as described above, a pressure loss can be reduced while maintaining a cooling capacity. Further, since a sufficient air volume of cooling air passes through the heat pipe unit 12-2 disposed as described above, a decrease in air volume at the heat pipe unit 12-2 can be suppressed, while improving a cooling capacity by high fin efficiency. As a result, it is possible to achieve equalization of temperatures of the heating elements 10-1 to 10-8 disposed along the flow direction F of the cooling air. Also, since it is not necessary to increase the number of fins or the number of heat pipes, or to provide a large-sized fan for increasing an air volume, an increase in costs for molds and production costs can be avoided, and further, an increase in an installation space for the cooling apparatus or an increase in power consumption can be avoided.

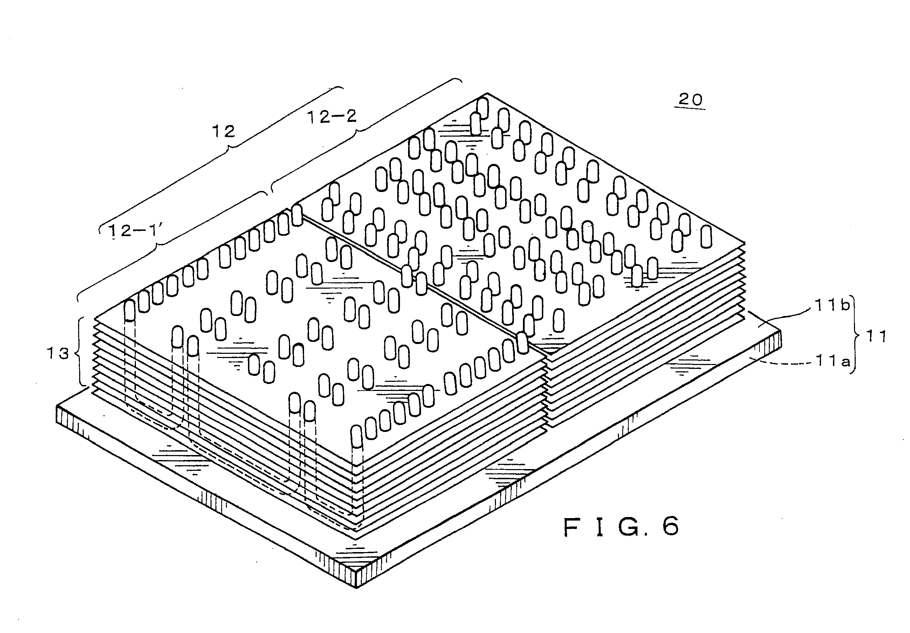

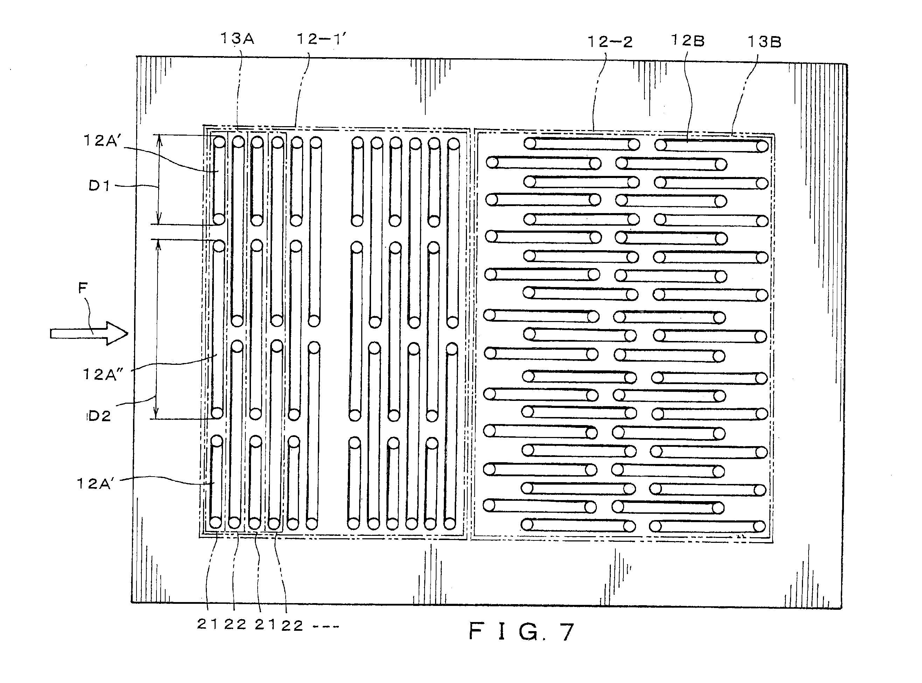

FIG. 6 is a perspective view schematically showing a configuration of a cooling apparatus according to a second embodiment of the present invention, and FIG. 7 is a plan view of the cooling apparatus of FIG. 6. Note that, since the configuration of the cooling apparatus of the second embodiment is basically the same as that of the cooling apparatus of the first embodiment, differences will be described in the description below.

As shown in FIG. 6, the cooling apparatus 20 includes the heat pipe group 12 that is thermally connected to the heat receiving block 11. The heat pipe group 12 is disposed upstream in the cooling air and has a heat pipe unit 12-1' constituted by the plurality of heat pipes 12A disposed substantially perpendicularly to the flow direction F of the cooling air.

The heat pipe unit 12-1' is constituted by a plurality of heat pipes 12A', 12A" arranged in rows, and two types of heat pipes differing in the length of the secured portion are used in this heat pipe unit 12-1'. In the example shown in FIG. 7, the length of the secured portion, that is, a width dimension D1, of the U-shaped heat pipe 12A' is about a quarter of the width dimension of fin 13A, and a width dimension D2 of the heat pipe 12A" is about a half of the width dimension of the fin 13A.

Also, the heat pipe unit 12-1' has a heat pipe row 21 in which three heat pipes, i.e., heat pipes 12A', 12A" and 12A' arranged in this order, and a heat pipe row 22 constituted by aligning two heat pipes, i.e., heat pipes 12A" and 12A". The heat pipe rows 21 and 22 are alternately disposed along the flow direction at an equal interval.

With the configuration described above, as compared to the aforementioned first embodiment, an arrangement pitch of the extended portions of the heat pipes in a direction perpendicular to the flow direction F is about a half in appearance when the heat pipe unit 12-1' is viewed in a plan view, and, the cooling capacity at the heat pipe unit 12-1' can be further improved.

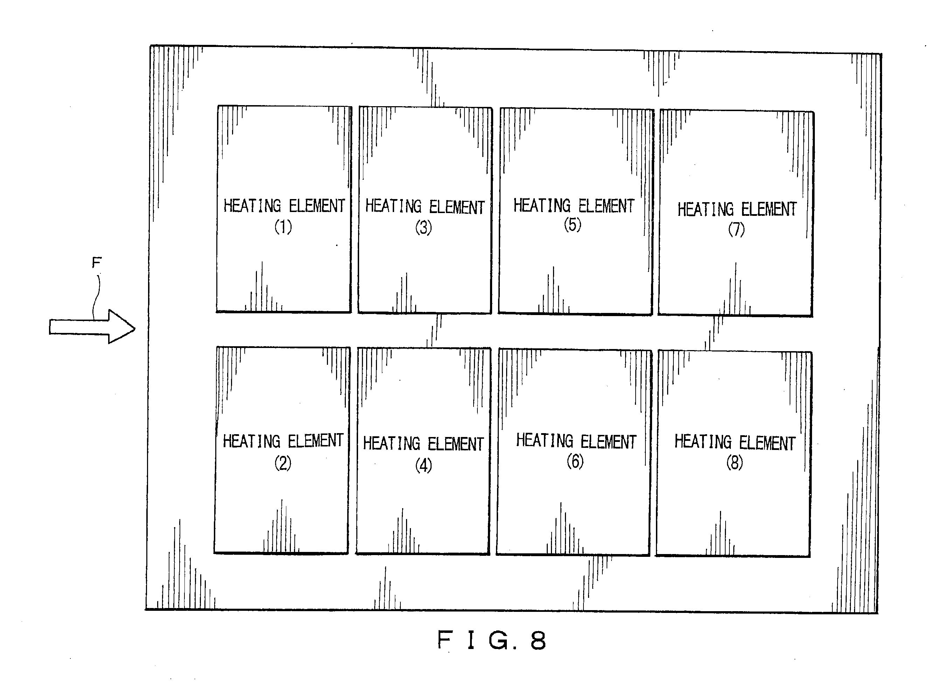

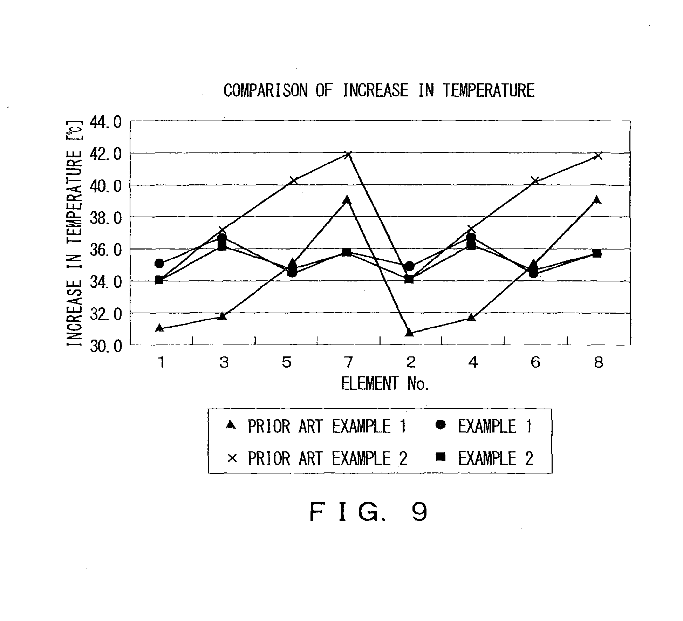

Referring now to FIGS. 8 and 9, the difference between the temperature of the heat receiving block whereto the cooling apparatus of the present invention is applied and the temperature of the heat receiving block whereto the prior art cooling apparatus is applied will be described. The temperatures of the heat receiving block shown in FIG. 9 and Table 1 indicated below were obtained by numerical analysis (simulation). In the numerical analysis, the cooling apparatus of Example 1 was configured to include an aluminum heat receiving block having a length of 600 mm, a width of 800 mm, and a thickness of 23 mm, 72 heat pipes having a substantially U-shaped and φ 12.7, and 70 cooling fins of 450 mm x 600 mm x 0.5 mm at a 3.0 mm pitch. It is to be noted that these 72 heat pipes are disposed similarly to the heat pipes in the cooling apparatus shown in FIG. 1.

The configuration of the cooling apparatus of Example 2 is the same as that of Example 1, except that 72 heat pipes are disposed similarly to those in the cooling apparatus shown in FIG. 6.

On the other hand, the configuration of the cooling apparatus of Prior Art Example 1 is the same as Example 1 except that a heat pipe unit which is the same as the downstream heat pipe unit is disposed instead of the upstream heat pipe unit of Example 1. That is, in Prior Art Example 1, all the heat pipes are disposed substantially parallel to the flow direction of the cooling air. Also, the configuration of the cooling apparatus of Prior Art Example 2 is the same as Example 1 except that a heat pipe unit that is the same as the upstream heat pipe unit is disposed instead of the downstream heat pipe unit of Example 1. That is to say, in Prior Art Example 1, all the heat pipes are disposed substantially perpendicularly to the flow direction of the cooling air.

In the cooling apparatuses of the aforementioned Examples 1 and 2 and Prior Art Examples 1 and 2, eight heating elements with a heat generation amount of 1,750 W are disposed in the heat receiving block in 2 rows x 4 columns and referred to as upstream side heating elements (1) to No. 4 and downstream side heating elements No. 4 to No. 8, as shown in FIG. 8. Here, the upstream side heat pipe unit is disposed directly above the upstream heating elements (1) to No. 4 and the downstream side heat pipe unit is disposed directly above the downstream side heating elements No. 4 to No. 8, respectively. It is assumed that the cooling air of a predetermined air volume was introduced to the cooling apparatus for a predetermined period of time. Results of an analysis of temperatures of the heat receiving block corresponding to heating elements No. 1 to No. 8 are shown in Table 1. FIG. 9 shows a graph in which heat receiving block temperatures obtained by the numerical analysis is plotted for each of Examples and Prior Art Examples.

[TABLE 1]

**TABLE 1**

| | TEMPERATURE OF HEAT RECEIVING BLOCK (°C) | | | | | | | | MAXIMUM TEMPERATURE OF HEAT RECEIVING BLOCK (°C) | DIFFERENCE BETWEEN MAXIMUM TEMPEMTURE AND MINIMUM TEMPERATURE (°C) |
|---|---|---|---|---|---|---|---|---|---|---|
| | HEATING ELEMENT CORRESPOND TO HEAT RECEIVING BLOCK | | | | HEATING ELEMENT CORRESPONDING TO HEAT RECEIVING BLOCK | | | | | |
| | No. 1 | No. 3 | No. 5 | No. 7 | No. 2 | No. 4 | No. 5 | No. 6 | | |
| | UPSTREAM SIDE - DOWNSTREAM SIDE | | | | UPSTREAM SIDE - DOWNSTREAM SIDE | | | | | |
| EXAMPLE 1 | 35.1 | 37.0 | 34.5 | 35.7 | 35.0 | 36.9 | 34.4 | 35.5 | 37.0 | 2.6 |
| EXAMPLE 2 | 34.1 | 36.2 | 34.7 | 35.7 | 34.0 | 35.3 | 34.6 | 35.6 | 36.3 | 2.2 |
| PRIOR ART EXAMPLE 1 | 31.1 | 31.6 | 35.4 | 39.2 | 30.9 | 31.4 | 35.2 | 39.0 | 39.2 | 8.3 |
| PRIOR ART EXAMPLE 2 | 34.3 | 37.4 | 40.4 | 41.9 | 34.3 | 37.4 | 40.4 | 41.8 | 41.9 | 7.6 |

As shown in Table 1, in Example 1, although the heat receiving block temperature (heat receiving block temperature corresponding to heating elements No. 1 to No. 4) at the upstream side heat pipe unit is the same or slightly higher than the heat receiving block temperature in Prior Art Examples 1 and 2, the heat receiving block temperature (heat receiving block temperature corresponding to heating elements No. 5 to No. 8) at the downstream side heat pipe unit is sufficiently lower than Prior Art Examples 1 and 2. Thus, the cooling capacity at the downstream side heat pipe unit is improved. In Example 1, the maximum value of the heat receiving block temperature was 37.0 °C and the difference between the maximum value and the minimum value of the heat receiving block temperature was 2.6 °C. Both the maximum value and the difference between the maximum value and the minimum value were smaller than those in Prior Art Examples 1 and 2, and it is found that heat is substantially equalized over the entire heat receiving block.

Also, in Example 2, the heat receiving block temperature at the upstream side heat pipe unit is about the same as those in Prior Art Examples 1 and 2, and the heat receiving block temperature at the downstream side heat pipe unit is sufficiently lower than the heat receiving block temperature in Prior Art Examples 1 and 2. Thus, the cooling capacity at the downstream side heat pipe unit is improved. In Example 2, the maximum value of the heat receiving block temperature was 36.3 °C and the difference between the maximum value and the minimum value of the heat receiving block temperature was 2.2 °C. The maximum value and the difference between the maximum value and the minimum value were both smaller than those in Prior Art Examples 1 and 2, and heat is substantially equalized over the entire heat receiving block.

In Prior Art Example 1, the temperature of heating elements No. 5 to No. 8 on the downstream side is increased, and the difference between the maximum value and the minimum value of the heat receiving block temperature is 8.3 °C, which is a large difference. This can be considered that, in Prior Art Example 1, since a plurality of heat pipes are disposed substantially in parallel along the flow direction of the cooling air and are provided evenly at a small pitch, although heat transfer efficiency to the fins is high, the heat pipe becomes a resistance for the cooling air and causes an increase in the pressure loss, the cooling capacity at the downstream side heat pipe unit has decreased.

Also, in Prior Art Example 2, the temperature of heating elements No. 5 to No. 8 on the downstream side increases, and the difference between the maximum value and the minimum value of the heat receiving block temperature is 7.6 °C, which is a large difference. This can be considered that, since the plurality of heat pipes are disposed substantially perpendicularly to the flow direction of the cooling air, although the heat pipes are unlikely to become a resistance for the cooling air and the pressure loss of the entire heat pipe unit becomes smaller, there is an increase in the distance between the extended portions of the heat pipe that causes a decrease in the fin efficiency decreases, resulting in a decrease in cooling capacity at the downstream side heat pipe unit.

Based on the analysis results described above, it can be seen that, with the configuration and the arrangement of the cooling apparatuses of Examples 1 and 2, the cooling capacity at the heat pipe unit, specifically, the cooling capacity at the downstream side heat pipe unit can be particularly improved as compared to Prior Art Examples 1 and 2. Also, since there is no variation in the cooling capacity with respect to the flow direction of the cooling air, the heat is substantially equalized in the entirety of the heat receiving block. Therefore, even if a plurality of heating elements are disposed along the flow direction, equalization of the heat in these heating elements can be achived.

In the cooling apparatuses of the aforementioned examples 1 and 2, eight heating elements have the same amount of heat generation. However, even if an amount of heat generation is different, an effect of heat equalization can be obtained as compared to Prior Art Examples 1 and 2. Also, a cooling fin pitch of the downstream side heat pipe unit is the same as a cooling fin pitch of the upstream side heat pipe unit, but a further heat equalization can be achieved by making these cooling fin pitches different.

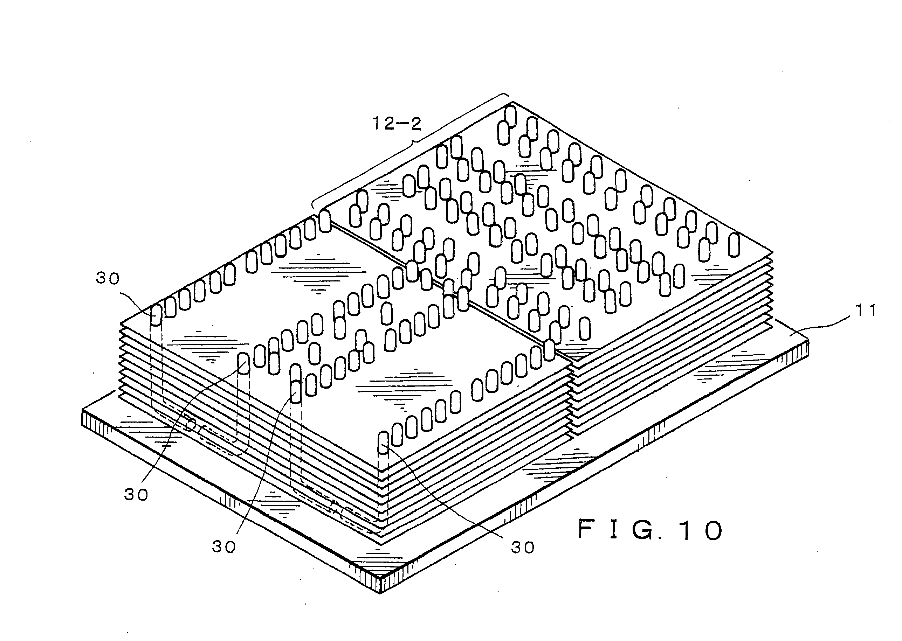

Also, in the aforementioned embodiment, heat pipes having a substantially U-shape in a side view is used. However, it is not limited thereto, and the heat pipes 30 having a substantially L-shape in a side view may be used. Here, the substantially L-shaped heat pipes 30 may be disposed as shown in FIG. 10, or may be disposed to face each other or may be disposed to be oriented in the same direction. Accordingly, the arrangement pitch can be selected from a wider range and an increase in the production cost can be suppressed by using the same heat pipe.

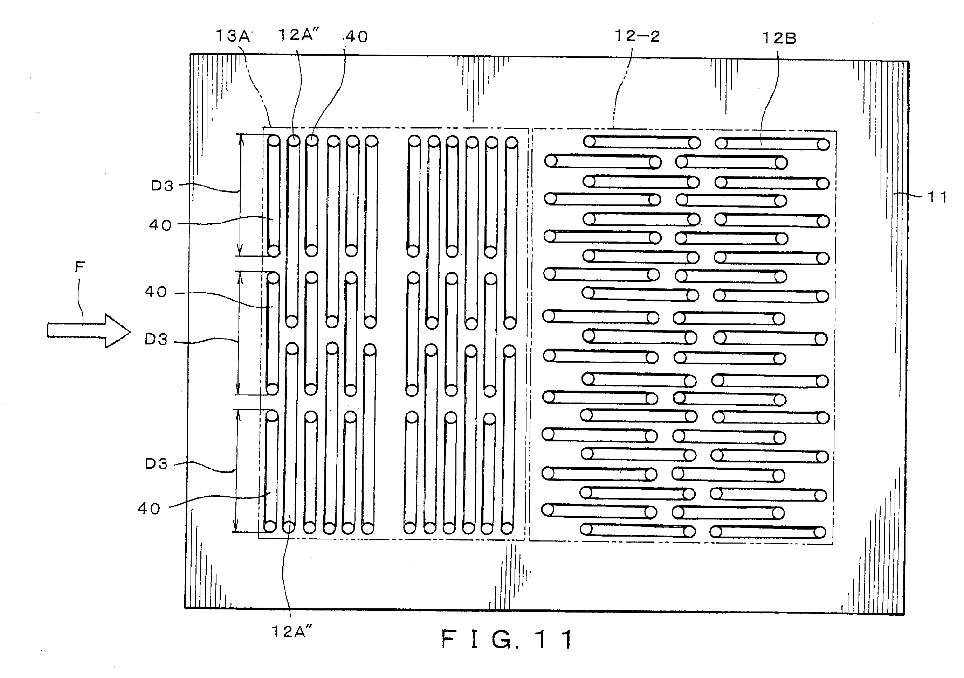

The heat pipe row 21 of the aforementioned embodiment is constituted by three heat pipes, that is, the heat pipes 12A', 12A", 12A' arranged in this order, it is not limited thereto, and as shown in FIG. 11, three heat pipes 40 may be aligned. In this case, the secured portion of the U-shaped heat pipe 40 has a length, that is, a width dimension D3, of one-third of the width dimension of the fin 13A. This configuration can also improve the cooling capacity at the heat pipe unit 12-1'.

The arrangement may be such that the arrangement pitch of one heat pipe row is different from the arrangement pitch of the heat pipe row adjacent to the one heat pipe row. Specifically, it is preferable that the arrangement pitch of the one heat pipe row is 1/α of the width dimension of the fin 13A (α is an integer greater than or equal to 2), and an arrangement pitch in the adjacent heat pipe row is 1/β of the width dimension of the fin 13A (β≠α, β is an integer greater than or equal to 2). For example, when α=3 and β=2, the arrangement is the same as the heat pipe unit shown in FIG. 11. This configuration can also improve the cooling capacity at the upstream side heat pipe unit.

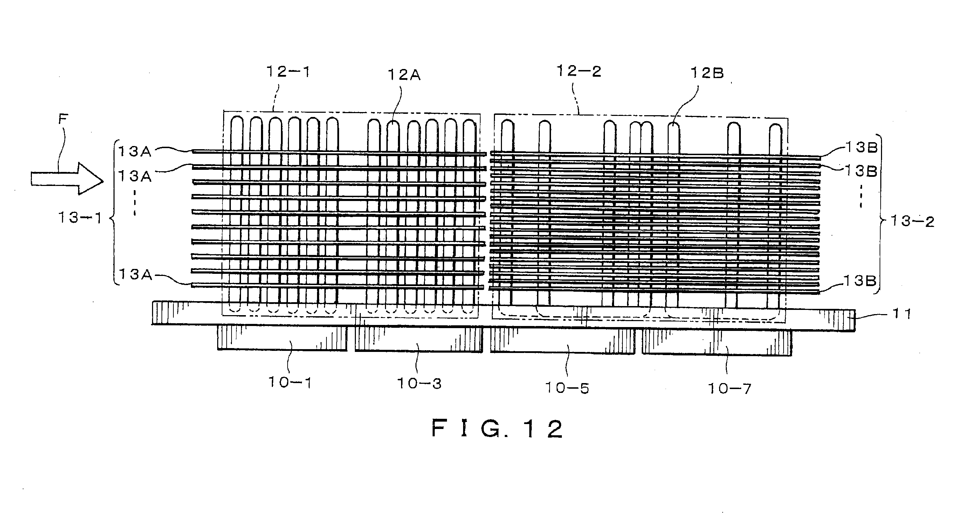

With the heat dissipation fin group 13 of the aforementioned embodiment, the number of fins in the fin unit 13-1 is the same as the number of fins in the fin unit 13-2. However, it is not limited thereto, and the number of fins in the fin unit 13-1 may be less than the number of fins in the fin unit 13-2, as shown in FIG. 12. Thereby, the fin efficiency in the fin unit 13-1 can be further improved, while further reducing the pressure loss in the fin unit 13-1.

In the above description, the cooling apparatus of the present embodiment has been described. However, the present invention is not limited to the embodiment described above, and various alterations and modifications can be made based on a technical concept of the present invention.

### List of Reference Signs

- 1: cooling apparatus
- 10-1, 10-2, 10-3, 10-4: heating element
- 10-4, 10-5, 10-6, 10-8: heating element
- 11: heat receiving block
- 11a, 11b: surface
- 12: heat pipe group
- 12-1, 12-2, 12-3: heat pipe unit
- 12-1': heat pipe unit
- 12A, 12B, 12C: heat pipe
- 12A', 12A": heat pipe
- 13: heat dissipation fin group
- 13-1, 13-2: fin unit
- 13A, 13B: fin
- 20: cooling apparatus
- 21: heat pipe row
- 22: heat pipe row
- 30: heat pipe
- 40: heat pipe
- 121: secured portion
- 121': secured portion
- 122,123: extended portion
- 122', 123': extended portion

## Claims

1. A cooling apparatus comprising:
a heat receiving block that is thermally connected to a heating element;
a heat pipe group that is thermally connected to the heat receiving block; and
a heat dissipation fin group that is thermally connected to the plurality of heat pipes,
the heat pipe group having
a first heat pipe unit disposed upstream in a cooling air, the first heat pipe unit being constituted by a plurality of heat pipes disposed substantially perpendicularly to the flow direction of the cooling air, and
a second heat pipe unit disposed downstream in the cooling air, the second heat pipe unit being constituted by a plurality of heat pipes disposed substantially parallel to the flow direction of the cooling air.

2. The cooling apparatus according to claim 1, wherein the first heat pipe unit is constituted by a plurality of U-shaped or L-shaped heat pipes,
the heat pipe having a first secured portion secured to the heat receiving block and a first extended portion that extends from at least one end of the first secured portion,
a plane specified by the first secured portion and the first extended portion being disposed substantially perpendicular to the flow direction of the cooling air.

3. The cooling apparatus according to claim 1, wherein the second heat pipe unit is constituted by a plurality of U-shaped or L-shaped heat pipes,
the heat pipe having a second secured portion secured to the heat receiving block and a second extended portion that extends from at least one end of the second secured portion,
a plane specified by the second secured portion and the second extended portion being substantially parallel to the flow direction of the cooling air.

4. The cooling apparatus according to claim 1, wherein the first heat pipe unit is constituted by the plurality of heat pipes arranged in rows,
the first heat pipe unit having one heat pipe row in which the heat pipes are arranged in a row at a predetermined pitch, and another heat pipe row in which the heat pipes are arranged in a row at a pitch different from the predetermined pitch.

5. The cooling apparatus according to claim 4, wherein the one heat pipe row has an arrangement pitch of 1/α of a width dimension of the heat dissipation fin (α is an integer greater than or equal to 2), and
the other heat pipe row has an arrangement pitch of 1/β of the width dimension of the heat dissipation fin (β≠α, β is an integer greater than or equal to 2).

6. The cooling apparatus according to claim 4, wherein the one heat pipe row and the other heat pipe row are arranged alternately in the flow direction of the cooling air.

7. The cooling apparatus according to claim 1, wherein the second heat pipe unit is constituted by a plurality of heat pipes arranged in rows at a predetermined pitch.
